Europäisches Patentamt

European Patent Office

Office européen des brevets

(11) Publication number: **0 322 519**
**A2**

## EUROPEAN PATENT APPLICATION

(21) Application number: 88116085.7

(22) Date of filing: 29.09.88

(51) Int. Cl.4: **H03F 3/26 , H03F 3/45**

(30) Priority: 31.12.87 US 140190

(43) Date of publication of application:
**05.07.89 Bulletin 89/27**

(84) Designated Contracting States:
**DE FR GB IT**

(71) Applicant: **MOTOROLA, INC.**
**1303 East Algonquin Road**
**Schaumburg Illinois 60196(US)**

(72) Inventor: **Vyne, Robert Leonard**
**5623 S. Holbrook Drive**
**Tempe Arizona 85283(US)**
Inventor: **Susak, David M.**
**283 S. Cypress Court**
**Chandler Arizona 85226(US)**
Inventor: **Davis, William Folsom**
**1616 E. Julie Drive**
**Tempe Arizona 85283(US)**

(74) Representative: **Ibbotson, Harold et al**
**Motorola Ltd Patent and Licensing**
**Operations - Europe Jays Close Viables**
**Industrial Estate**
**Basingstoke Hampshire RG22 4PD(GB)**

(54) Operational amplifier utilizing trimmable current sources.

(57) The first and second inputs of an operational amplifier (2) are each coupled to a trimmable JFET current source. Each JFET current source (J1 or J3) comprises a first JFET having a gate coupled to a first source of supply voltage, a source coupled via an adjustable resistor ($R_{T1}$, $R_{T2}$) to the first source of supply voltage, and a drain coupled respectively to either the first or second input of the operational amplifier. The drain terminal of each JFET is coupled to the source terminal of an additional JFET (J2 or J4) which has its drain coupled to a second source of supply voltage and its gate coupled to an input potential.

# OPERATIONAL AMPLIFIER UTILIZING TRIMMABLE CURRENT SOURCES

## Background of the Invention

This invention relates generally to operational amplifier circuitry, and more particularly, to a junction field effect transistor (JFET) current source which generates a current ($I_D$) which is adjustable and substantially equal to the saturation current ($I_{DSS}$) of the JFET and substantially tracks $I_{DSS}$ over temperature. This current ($I_D$) biases JFET followers associated with a differential input stage producing a low input offset voltage ($V_{OS}$) and a low temperature coefficient of $V_{OS}$.

In an operational amplifier which utilizes JFET followers for driving a PNP differential stage, it is desirable that the JFET followers be supplied each with a current equal to $I_{DSS}$ (the drain current with the gate and source shorted). In this manner, the gate to source voltage ($V_{GS}$) of the JFET followers is equal to zero with a temperature coefficient which is equal to zero. Furthermore, with $V_{GS}$ of each JFET follower (i.e. $V_{GS1}$ and $V_{GS2}$) equal to zero, the offset voltage of the JFET followers ($V_{GS1} - V_{GS2}$) equals zero as is the temperature coefficient of this JFET offset voltage. In the past, it could not be assured that the required currents to bias the JFET followers equal $I_{DSS}$ of the JFET followers due to process variations.

One attempt to solve this problem utilized a JFET having a source terminal coupled to a source of supply voltage and an adjustable resistor coupled between the gate and source terminals. A reference current is supplied to the resistor, which reference current is proportional to the JFETS pinch-off voltage. The desired current appears at the drain of the JFET. Such an arrangement is shown and described in U.S. Patent No. 4,736,126 entitled "TRIMMABLE CURRENT SOURCE" issued on April 5, 1988, and assigned to the assignee of the present invention. When used in conjunction with a single operational amplifier, this approach provided extremely satisfactory results. Unfortunately, its use on an integrated circuit comprised of multiple operational amplifiers result in an increase in layout complexity.

## Summary of the Invention

It is an aspect of the present invention to provide improved operational amplifier circuitry.

It is a further aspect of the present invention to provide a current source for use in conjunction with an operational amplifier which generates a current substantially equal to $I_{DSS}$ and which substantially tracks $I_{DSS}$ over temperature.

It is still a further aspect of the present invention to provide an improved circuit for generating an adjustable current which is substantially equal to $I_{DSS}$ for use in conjunction with operational amplifiers and which does not present significant layout problems on integrated circuits.

It is still a further aspect of the present invention to provide an adjustable current source which is substantially equal to $I_{DSS}$ of a JFET follower associated with a differential input stage of an operational amplifier.

According to a broad aspect of the invention there is provided a circuit for generating a current which is adjustable and substantially equal to $I_{DSS}$ - (where $I_{DSS}$ is the drain current of a JFET when its source and gate terminals are shorted) comprising a first JFET having a gate terminal for coupling to a first source of supply voltage, and having source and drain terminals; an adjustable resistor for coupling between said source terminal and said first source of supply voltage; and a second JFET having a source terminal coupled to the drain terminal of said first JFET, a gate terminal coupled to an input terminal, and a drain terminal for coupling to a second source of supply voltage. The current through first and second JFETS and adjustable resistor causes the gate to source voltage of first and second JFETS to be equal.

According to a further aspect of the invention there is provided an operational amplifier circuit, comprising operational amplifier means having first and second inputs and having an output; a first JFET having a gate terminal for coupling to a first source of supply voltage, a drain terminal coupled to said first input and having a source terminal; a second JFET having a source terminal coupled to the drain terminal of said first JFET and to said first input, a drain terminal for coupling to said second source of supply voltage and a gate terminal for coupling to a first input potential; a third JFET having a gate terminal for coupling to said first source of supply voltage, a drain terminal coupled to said second input and having a source terminal; a fourth JFET having a drain terminal for coupling to said second source of supply voltage, a source terminal for coupling to the drain terminal of said third JFET and to said second input, and a gate terminal for coupling to a second input potential; a first adjustable resistor for coupling between the source terminal of said first JFET and said first source of supply voltage; and a second adjustable resistor for coupling between the source terminal of said third JFET and said first source of supply voltage.

## Brief Description of the Drawings

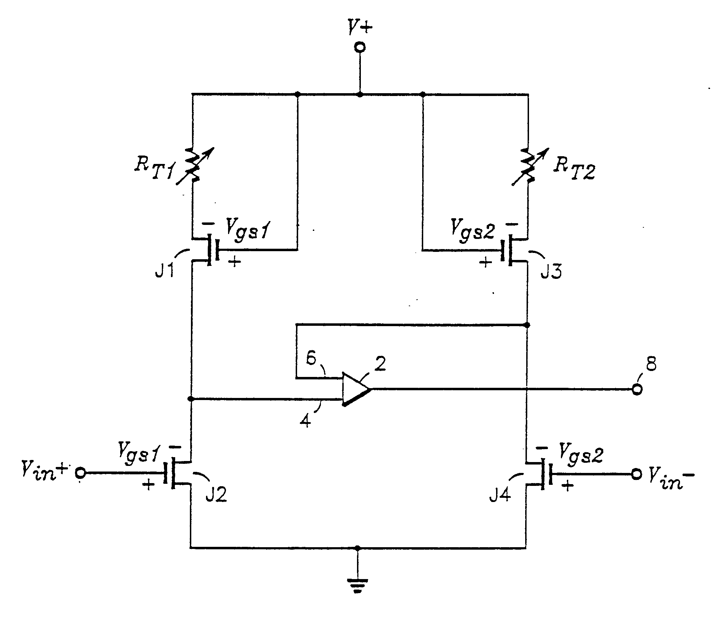

The above and other aspects, features and advantages of the present invention will be more clearly understood from the following detailed description taken in conjunction with the accompanying drawing which is a schematic diagram of the inventive adjustable current source and JFET followers associated with the differential input of an operational amplifier.

## Description of the Preferred Embodiment

In the drawing, there is shown an operational amplifier 2 having inputs 4 and 6 and an output terminal 8. The remainder of the circuit comprises JFET's J1, J2, J3 and J4 and adjustable resistors $R_{T1}$ and $R_{T2}$. The gate electrodes of JFETs J1 and J3 are coupled to a source of supply voltage $V+$ and their source electrodes are coupled via adjustable resistors $R_{T1}$ and $R_{T2}$ respectively to the source of supply voltage. The drain electrodes of J1 and J3 are coupled respectively to inputs 4 and 6 of operational amplifier 2. The drain electrodes of JFET's J2 and J4 are coupled to a second source of supply voltage (e.g. ground), and the source electrodes of J2 and J4 are coupled respectively to the drain electrodes of J1 and J3. The gate electrodes of JFETs J2 and J4 are coupled respectively to inputs $V_{in+}$ and $V_{in-}$. When $V_{in+}$ falls below $V_{in-}$, J2 and J4 cause the voltage at input terminal 4 of operational amplifier 2 to fall below the voltage at input 6 producing a negative output swing on output 8. Similarly, if $V_{in-}$ falls below $V_{in+}$, J4 and J2 cause the voltage at input 6 of JFET 2 to fall below that on input 4 producing a positive output swing on output 8.

Offset voltage may be trimmed in the following manner. If $R_{T1}$ is adjusted to be zero, then the gate to source voltage $V_{GS1}$ of JFET J1 will equal zero, and the drain current $I_D$ will equal the saturation current $I_{DSS}$ of J1. Similarly, if $R_{T2}$ is adjusted to be zero, $V_{GS2}$ will fall to zero and the drain current of J3 will equal the saturation current ($I_{DSS}$) of J3. By increasing the value of $RT_1$, the drain current of J1 will decrease and $V_{GS1}$ will increase. Similarly, increasing $R_{T2}$ will cause the drain current of J3 to decrease, and $V_{GS2}$ will increase. Thus, by properly adjusting $R_{T1}$ and/or $R_{T2}$, the gate to source voltages of J1 and J3 respectively may be varied between zero and the respective pinch-off voltage.

Assuming that J1 and J2 are substantially matched and J3 and J4 are substantially matched, then the gate to source voltage of J2 will substantially equal that of J1, and the gate to source voltage of J4 will substantially equal that of J3. Therefore, by properly adjusting $R_{T1}$ and/or $R_{T2}$, any offset voltage appearing across inputs $V_{IN}+$ and $V_{in}-$ of the operational amplifier may be adjusted to zero. Therefore, any offset voltage appearing across inputs 4 and 6 of amplifier 2 and/or any offset voltage due to JFET mismatches can be compensated for.

The above description is given by way of example only. Changes in form and details may be made by one skilled in the art without departing from the scope of the invention as defined by the appended claim.

## Claims

1. A circuit (J1, J2, $R_{T1}$ or J3, J4, $R_{T2}$) for generating a current which is adjustable and substantially equal to $I_{DSS}$ where $I_{DSS}$ is the drain current of a JFET when its source and gate terminals are shorted, comprising:
a first JFET (J1 or J3) having a gate terminal for coupling to a first source of supply voltage, and having source and drain terminals;
an adjustable resistor ($R_{T1}$ or $R_{T2}$) for coupling between said source terminal and said first source of supply voltage; and
a second JFET (J2 or J4) having a source terminal coupled to the drain terminal of said first JFET, a gate terminal coupled to an input terminal, and a drain terminal for coupling to a second source of supply voltage.

2. An operational amplifier circuit, comprising:
an operational amplifier (2) having first and second inputs and having an output;
a first JFET (J1) having a gate terminal for coupling to a first source of supply voltage, a drain terminal coupled to said first input and having a source terminal;
a second JFET (J2) having a source terminal coupled to the drain terminal of said first JFET and to said first input, a drain terminal for coupling to said second source of supply voltage and a gate terminal for coupling to a first input potential ($V_{in+}$);
a third JFET (J3) having a gate terminal for coupling to said first source of supply voltage, a drain terminal coupled to said second input and having a source terminal;
a fourth JFET (J4) having a drain terminal for coupling to said second source of supply voltage, a source terminal for coupling to the drain terminal of said third JFET and to said second input, and a gate terminal for coupling to a second input potential ($V_{in-}$);

a first adjustable resistor ($R_{T1}$) for coupling between the source terminal of said first JFET and said first source of supply voltage; and

a second adjustable resistor ($R_{T2}$) for coupling between the source terminal of said third JFET and said first source of supply voltage.